# EUROPEAN PATENT SPECIFICATION

(11) **EP 2 396 451 B1**
(45) Date of publication and mention of the grant of the patent: **07.11.2012**
(21) Application number: 10703949.7
(22) Date of filing: 10.02.2010
(51) Int. Cl.: C23C 16/40, C23C 16/02, B05D 7/24

(54) **TWO LAYER BARRIER ON POLYMERIC SUBSTRATE**
ZWEISCHICHTIGE BARRIERE AUF POLYMERSUBSTRAT
BARRIÈRE À DEUX COUCHES SUR UN SUBSTRAT POLYMÈRE

(30) Priority: 12.02.2009 EP 09152674
(43) Date of publication of application: 21.12.2011
(73) Proprietor: Fujifilm Manufacturing Europe BV, 5047 TK Tilburg (NL)
(72) Inventor: DE VRIES, Hindrik, NL-5047 TK Tilburg (NL); VAN DE SANDEN, Mauritius, NL-5017 JH Tilburg (NL)
(74) Representative: Mayall, John
(86) International application number: PCT/GB2010/050207
(87) International publication number: WO 2010/092383

(56) References cited:
- EP-A- 1 383 359
- EP-A- 1 630 250
- WO-A-03/066932
- WO-A-2005/049228
- WO-A-2006/036461
- WO-A-2008/147184
- WO-A-2009/007654
- US-A- 5 576 076

## Description

### Field of the invention

The present invention relates to a plasma treatment apparatus and a method for treatment of a moving substrate using an atmospheric pressure glow discharge plasma in a treatment space. More in particular, the present invention relates to a method for producing a polymeric substrate using an atmospheric pressure glow discharge plasma in a treatment space formed between two or more opposing electrodes connected to a power supply, and in a further aspect, to a plasma treatment apparatus for treating a substrate, the plasma treatment apparatus comprising at least two opposing electrodes and a treatment space between the at least two opposing electrodes, the at least two electrodes being connected to a plasma control unit for generating an atmospheric pressure glow discharge plasma in the treatment space, and a gas supply device being arranged to provide a gas mixture in the treatment space in operation.

### Prior art

The present invention is amongst others applicable to the enveloping and/or supporting substrate of an electronic device comprising a conductive polymer with e.g. an electronic device, a photovoltaic cell and/or semi-conductor devices.

Optical glass has been previously used in electronic display applications as substrate because it is able to meet the optical and flatness requirements and has thermal and chemical resistance and good barrier properties. Main disadvantage of the use of glass is related to its weight, inflexibility and fragility. For this reason flexible plastic materials have been proposed as replacement for glass.

Disadvantages of the use of polymeric substrates are their lower chemical resistance and inferior barrier properties. There is no polymeric substrate alone which can meet the requirements of a water vapour transmission rate (WVTR) in the order of 10⁻⁶ g/m²*day or less and oxygen transmission rate in the order of 10⁻⁵ cc/m²*day or lower, which are needed in case of use of these substrates in electronic devices.

One of the draw-backs here is the stability of the atmospheric plasma's. To improve this stability, various solutions have been provided for example those described in US-6774569, EP-A-1383359, EP-A-1547123 and EP-A-1626613. Another drawback is dust formation upon using an atmospheric glow discharge plasma for deposition purposes. For example, U.S. Patent 5,576,076 teaches the deposition of silicon oxide on a substrate using an atmospheric glow discharge plasma in the presence of a silane in which the deposition of silicon oxide tends to be in the form of a powder.

International patent application WO2005049228 describes a process for depositing a coating on a substrate, using tetraalkylorthosilicate and an atmospheric glow discharge plasma, where allegedly dust formation is prevented. In this publication a perforated electrode is used.

Another method to prevent dust formation is to use glow discharge plasma's at low pressure as described for example in Japanese patent application abstract 07-074110.

In the article 'Formation Kinetics and Control of Dust Particles in Capacitively-Coupled Reactive Plasmas' by Y. Watanabe et al., Physica Scripta, Vol. T89, 29-32, 2001, a description is given of a study at reduced pressure of the influence of both the pulse on-time (tₒₙ) and pulse off-time (t_{off}) in capacitively coupled RF discharges (13.56 MHz). It was shown that an increase in tₒₙ duration increases the size and volume fraction of clusters, though the most significant increase occurs above pulse on-time of 10 ms and longer.

It is a known fact, that atmospheric pressure glow discharge plasma's used for deposition of a chemical compound or chemical element suffer from dust formation by which formation of a smooth surface cannot be obtained and the used equipment will accumulate the dust in a short period of time resulting in products with worse barrier properties as the roughness of the barrier layer.

In the article "Deposition of dual-layer of SiOₓ/SiOₓC_{y}N_{w}H_{z} by Townsend dielectric barrier discharge " by Maechler et al. it is described that a dual layer barrier is formed on a polymer substrate. The method uses an atmospheric pressure Townsend discharge mode (different from Glow discharge mode) in a treatment space. A first (shield) layer is deposited of organic material SiOₓC_{y}N_{w}H_{z} after which a SiOₓ barrier layer is deposited. The article also discloses that a SiOₓ coating directly deposited on a polymer in the atmospheric pressure Townsend discharge induces damages of the polymer resulting in poorer barrier properties than for uncoated polymer. The best result reported to be achieved is a 10-fold improvement of the barrier properties (Barrier Improvement factor BIF=10).

Further WO2007139379, filed by applicant, describes the process for depositing inorganic layers on a substrates using a predefined tₒₙ time and a predefined gas-composition for preventing the formation of dust in the treatment space.

### Summary of the invention

The present invention seeks to provide a method allowing the control of generation of specific species in the gas composition used in an atmospheric pressure glow discharge plasma, to enable controlled reactant processes in the plasma, by which deposition of inorganic layers on a polymeric substrate can be achieved under less restricted control as previously reported in the prior art for instance due to formation of dust.

According to the present invention, a method according to the preamble defined above is provided, comprising
a) depositing a first (or buffer) layer of inorganic material on a polymeric substrate using a gas composition in the treatment space comprising a precursor and oxygen, said oxygen having a concentration of 2 % or less, and controlling the power supply to provide an energy across a gap between the two or more opposing electrodes of 30 J/cm² or less,
b) depositing a second (or barrier) layer of inorganic material on the first layer using a gas composition in the treatment space comprising a precursor and oxygen, said oxygen having a concentration of 3 % or higher, and controlling the power supply to provide an energy across the gap between the two or more opposing electrodes of 40 J/cm² or higher.

The measure of energy in J/cm² expresses the specific energy directed at the substrate, not the power (W/m²). By controlling the at least two depositions according to this method substrates can be obtained having excellent barrier properties in comparison to results achieved in prior art systems and methods. In a further embodiment, the oxygen concentration when depositing the first layer is 0.5% or less. This provides an improvement of the barrier properties compared to a value of 2% or less.

In further embodiments, the energy provided during deposition of the first layer is 10J/cm² or less, or even 5J/cm² or less. Experiments have shown that these embodiments provide a further improvement of barrier characteristics.

Also the process parameters used during deposition of the second layer may be varied to obtain improved barrier characteristics. E.g. the energy provided during deposition of the second layer is 80J/cm² or higher in a further embodiment. Also, in an even further embodiment, the oxygen concentration when depositing the second layer is 4% or higher.

In a further embodiment, the first layer of inorganic material is deposited until a thickness of 3 to 50 nm has been obtained. This is sufficient to provide a buffer layer for the second or barrier layer.

The substrate is a moving substrate in a further embodiment, which is moved through the treatment space. The treatment space may be a single treatment space used for depositing both the first and second layer, or a separate treatment space may be provided for each of the two layers.

In an even further embodiment, the substrate has an average surface roughness Rₐ of 2nm or less. This provides a good starting point for depositing an effective first layer.

The power supply provides the energy with a duty cycle between 90 and 100%, e.g. a duty cycle of 100%, in a further embodiment, allowing high growth rates of the layers.

A plasma treatment apparatus is provided as defined above, in which the plasma control unit and gas supply device are arranged to execute the method according to any one of the embodiments described above. This plasma treatment apparatus further comprises a substrate movement arrangement in an embodiment.

The present invention relates to a polymeric substrate having a dual layer barrier, in which a first layer comprises an inorganic buffer layer having a Carbon content (such as a layer comprising Si, C and oxygen or nitrogen content), and a second layer comprises an inorganic barrier layer (e.g. of SiO₂ or SiN₂). Such a polymeric substrate may be produced using the method embodiments or apparatus embodiments as described above. In an embodiment, the C-content is higher than or equal to 2%. This has as a technical effect that the first layer is not providing a barrier, but a good buffer layer for the second or barrier layer. To provide a good buffer layer, the first layer has a thickness of between 3 and 50 nm in a further embodiment. Furthermore to obtain good barrier properties, the second layer has a thickness of 40 nm or more.

The present invention relates to the use of a polymeric substrate according to one of the embodiments described above, obtained by the method embodiments described above, or obtained by using the plasma treatment apparatus embodiments as described above, for production of organic light emitting diodes (OLED) or photo-voltaic (PV) cells.

### Short description of drawings

The present invention will be discussed in more detail below, using a number of exemplary embodiments, with reference to the attached drawings, in which
Fig. 1 shows a schematic view of a plasma treatment apparatus in which the present invention may be embodied;
Fig. 2 shows a schematic view of an electrode configuration used in the plasma treatment apparatus of Fig. 1 according to an embodiment of the present invention;
Fig. 3 shows a schematic view of part of the plasma treatment apparatus for processing a substrate in the form of a web; and
Fig. 4 shows a cross sectional view of a treated substrate having two layers applied using embodiments of the present invention.

### Detailed description of exemplary embodiments

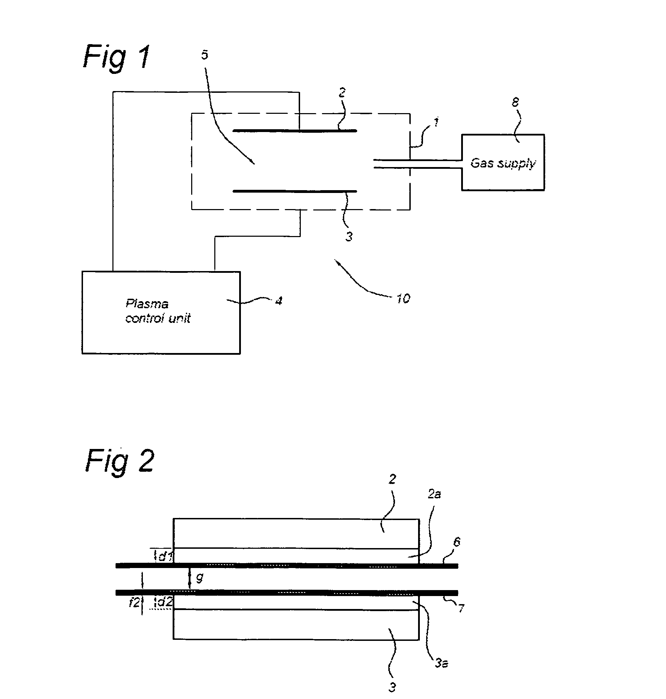

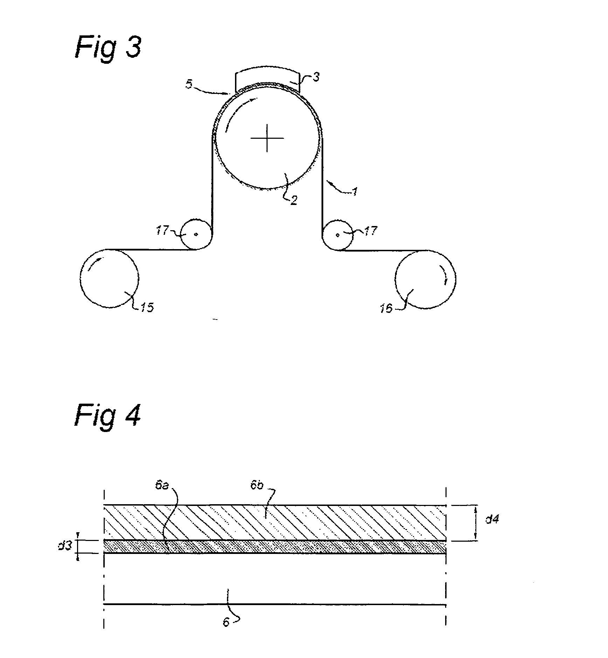

Fig. 1 shows a schematic view of a plasma treatment apparatus 10 in which the present invention is embodied and may be applied. A treatment space 5, which may be a treatment space within an enclosure 1 or a treatment space 5 with an open structure, comprises two opposing electrodes 2, 3. A substrate 6, or two substrates 6, 7 can be treated in the treatment space 5, in the form of flat sheets (stationary treatment, shown in Fig. 2) or in the form of moving webs (as shown in Fig 3, using source roll 15, pick-up roll 16 and tension rollers 17). The electrodes 2, 3 are connected to a plasma control unit 4, which inter alia supplies electrical power to the electrodes 2, 3, i.e. functions as power supply.

Both electrodes 2, 3 may have the same configuration being flat orientated (as shown in Fig. 2) or both being roll-electrodes. Also different configurations may be applied using roll electrode 2 and a flat or cylinder segment shaped electrode 3 opposing each other, as shown in the embodiment of Fig. 3.

A roll-electrode 2, 3 is e.g. implemented as a cylinder shaped electrode, mounted to allow rotation in operation e.g. using a mounting shaft or bearings. The roll-electrode 2, 3 may be freely rotating, or may be driven at a certain angular speed, e.g. using well known controller and drive units.

Both electrodes 2, 3 can be provided with a dielectric barrier layer 2a, 3a (see the detailed schematic view in Fig. 2). The dielectric layer 2a on the first electrode 2 has a thickness of d1 (mm), and the dielectric layer 3a on the second electrode 3 has a thickness of d2 (mm). In operation, the total dielectric distance d of the electrode configuration also includes the thickness of the (one or two) substrates 6, 7 to be treated, indicated by f1 (mm) and f2 (mm) in Fig. 2. Thus, the total dielectric thickness of the dielectric barrier in the treatment space 5 between the at least two opposing electrodes (2, 3) equals d = d1+f1+f2+d2.

In a further embodiment, both d1 and d2 are 0 and the only dielectric material forming the dielectric barrier is the substrate 6, 7. In case of two substrates 6 and 7, the total dielectric thickness in this case is d= f1 + f2.

In still another embodiment both d1 and d2 are 0 and only one substrate 6 is used. In this embodiment the total dielectric thickness equals f1, so d = f1. Also in this embodiment in which electrode 2 is not covered with a dielectric material it is possible to obtain a stable atmospheric glow discharge plasma.

The gap distance g indicates the smallest gap between the electrodes 2, 3 where an atmospheric pressure glow discharge plasma can exist in operation (i.e. in the treatment space 5), also called the free inter-electrode space. The dimensions of the electrodes 2, 3, dielectric barrier layers 2a, 3a, and gap g between the electrodes 2, 3, are predetermined in order to generate and sustain a glow discharge plasma at atmospheric pressure in the treatment space 5, in combination with the plasma control unit 4. The electrodes 2, 3 are connected to a power supply 4, which is arranged to provide electrical power to the electrodes for generating the glow discharge plasma under an atmospheric pressure in the treatment space 5 having a controlled energy supply.

In the treatment space 5, oxygen-gas and optionally other gasses are introduced using gas supply device 8, including a pre-cursor. The gas supply device 8 may be provided with storage, supply and mixing components as known to the skilled person. The purpose is to have the precursor decomposed in the treatment space 5 to a chemical compound or chemical element which is deposited on the substrate 6, 7. When using such embodiments in general dust formation is observed after very short deposition times and a smooth dust-free deposition cannot be obtained. In plasmas used for high quality applications (microelectronics, permeation barrier, optical applications) dust formation is a serious concern. For such applications the dust formation can compromise the quality of the coating e.g. in poor barrier properties.

Alternatively, a plurality of opposing electrodes 2, 3 is provided in the plasma treatment apparatus 10. The electrode 2, 3 which may be roll electrode implemented as cylinder shaped electrode mounted to allow rotation in operation e.g. using mounting shafts or bearings are connected to a power supply, being a part of the plasma control unit 4 as described with reference to Fig.1. The plasma control unit 4 is arranged to provide electrical power to the electrodes 2, 3 for generating the glow discharge plasma under an atmospheric pressure in the treatment space 5. In the treatment space 5, oxygen-gas and optionally other gasses are introduced from a gas supply device 8, including a pre-cursor. The gas supply device 8 may be provided with storage, supply and mixing components as known to the skilled person. The purpose is to have the precursor decomposed in the treatment space 5 to a chemical compound or chemical element which is deposited on a moving substrate 6, 7 resulting in an inorganic barrier layer.

Surprisingly it has been found that substrates 6, 7 can be made with excellent barrier properties after deposition of at least two layers of inorganic material 6a, 6b on a (moving) substrate 6, as shown schematically in Fig. 4. This is accomplished in one embodiment by controlling in the treatment space 5 the first inorganic layer 6a deposition to a thickness d3 of 3 to 50 nm using a gas composition comprising a controlled oxygen concentration of 2 % or less across a gap formed between the two or more opposing electrodes 2, 3, and a controlled energy supply of 30 J/cm² being supplied by the plasma control unit 4 to the substrate 6 in the treatment space 5.

The deposition of the first (thin) layer 6a does not result in a substrate producing any significant barrier property improvement compared to the barrier property of the polymeric substrate alone. When in addition a second deposition is applied to obtain a second inorganic layer 6b (with a thickness d4 as indicated in Fig. 4), using oxygen concentrations of above 3% in the treatment space and higher energy supply of 40 J/cm² or above substrates are obtained having excellent barrier properties.

In a further embodiment the oxygen concentration during deposition of the first layer 6a is controlled to 0.5% or less. This provides an even better result, as will be shown in more details using the examples described below. Furthermore, it has been found that keeping the energy supplied to a value of 10 J/cm² or less, also improves the barrier properties of the finished two-layer barrier product. Reduction of the energy to a value of 5 J/cm² even provided further improvement.

Without being bound to theory it is believed that by keeping both said oxygen concentration and energy supply during the first layer 6a deposition at the indicated levels, the interaction with the interface of the polymeric substrate surface remains low by less etching of oxygen radicals on the polymeric surface of substrate 6. As a result of the first inorganic deposition a small (i.e. a 3 to 50 nm deposition layer) buffer layer 6a is obtained having low roughness but poor barrier properties. During deposition of the second inorganic layer 6b this polymeric substrate etching phenomenon is prevented by the first layer 6a and higher oxygen-concentrations and/or energy supply may be used creating layered substrates having excellent barrier properties for the resulting combination of substrate 6 and inorganic layers 6a, 6b in total.

The precursor used in the deposition steps is e.g. HMDSO used in a concentration from 2 to 500 ppm.

Further the electrical power may be applied using a generator, which provides a sequence of e.g. sine wave train signals as the periodic electrical power supply for the electrodes. The frequency range may be between 10 kHz and 30 MHz, e.g. between 100 kHz and 500 kHz.

In a further embodiment dust formation is prevented by controlling the absolute value of the charge density (product of current density and time) generated during the power on pulse. In one embodiment this value is smaller than 5 micro Coulomb/cm², e.g. 2 or 1 microCoulomb/cm².

In order to obtain a deposition layer of uniform thickness and a smooth surface it is important to have a stable plasma e.g. preventing instabilities like streamers, filamentary discharges and the like. In a further embodiment the atmospheric glow discharge plasma is stabilized by stabilization means counteracting local instabilities in the plasma. By the power pulse of the power generator a current pulse is generated which causes a plasma current and a displacement current. The stabilization means are arranged to apply a displacement current change for controlling local current density variations associated with a plasma variety having a low ratio of dynamic to static resistance, such as filamentary discharges. By damping such fast variations using a pulse forming circuit an uniform glow discharge plasma is obtained. In a further embodiment, the displacement current change is provided by applying a change in the applied voltage to the two electrodes, the change in applied voltage being about equal to an operating frequency of the AC plasma energizing voltage, and the displacement current change having a value at least five times higher than the change in applied voltage.

In a further aspect, the present invention relates to the plasma treatment apparatus 10 wherein the gas supply device is arranged such that the gas composition in the treatment space can be controlled i.e. oxygen concentration can be controlled accurately.

For the first deposition step the oxygen concentration needs to be controlled accurately in the treatment space at 2% or even lower (e.g. 1 or even 0.5 % or lower). For the second deposition step the oxygen concentration needs to be controlled accurately in the same or different treatment space to above 3% (i.e. 4% or higher).

In a further embodiment, the gas supply device 8 may be arranged to perform the methods according to various embodiments described above.

In a further embodiment the power supply 4 as defined above is arranged as such that during the deposition of the first layer 6a the energy is controlled across the gap between said opposing electrodes 2, 3 to the (moving) substrate 6 to a value of 30 J/cm² or lower (e.g. 10 J/cm² or 5 J/cm² or less). For the deposition step of the second layer 6b the energy needs to be controlled across the gap between said opposing electrodes 2, 3 to the (moving) substrate 6 (in the same or different treatment space 5) to a value of 40 J/cm² or higher (e.g. 80 J/cm²).

In embodiments where moving substrates 6 are subjected to the deposition process as described above, the line speeds of the moving substrate 6 are in the range from 1 cm/min up to 100 m/min.

Furthermore, the plasma control unit 4 may comprise stabilization means arranged to perform the method according to further embodiments described above.

As mentioned above in relation to the various method embodiments, the present plasma treatment apparatus 10 may be used advantageously for depositing inorganic layers 6a, 6b on a substrate 6. For this, the plasma deposition apparatus may be arranged to receive a gas composition in the treatment space 5 comprising the precursor of a chemical compound or chemical element to be deposited in a concentration from 2 to 500ppm.

At atmospheric pressure high duty cycles could not be obtained until now. Pulsing at atmospheric pressure is one option as described in WO2007139379, filed by applicant, to suppress dust formation but has the disadvantage of a slower treatment of a surface. Surprisingly it was found however by arrangement of the plasma apparatus in this invention that the duty cycle at atmospheric pressure can be increased significantly to values between 90 and 100%, even up to a value of 100%. As stated before in the treatment space 5 a combination of gases is introduced comprising a precursor and oxygen and optionally a combination of other gasses.

In another embodiment the substrate 6 is heated during the plasma treatment. By heating the substrate 6 slightly, e.g. by heating electrode 2, 3 slightly, it was surprisingly found that the dust formation was reduced, or even eliminated, while still obtaining good deposition results on the substrate 6. When treating a polymer substrate 6, the temperature of, e.g., the electrode 2, 3 can be controlled to a temperature which is higher than normal in inorganic layer deposition on substrate 6 using uniform glow plasma discharges. The temperature may be raised up to the glass transition temperature of the material (e.g. a polymer) of the substrate 6, and in some cases even higher, up to the annealing temperature of the polymer substrate 6. Some commercially available polymer substrates are dimensionally stable above the glass transition temperature, i.e. after heating to a temperature above the glass transition temperature and then cooling down, no change in dimension is observed. In some instances this is even possible almost up to the temperature at which the polymer substrate starts to decompose. E.g. heat stabilized PET (Polyethylene Terephthalate) is available which is dimensionally stable up to 150°C, while the glass transition temperature is 80°C. Also, heat stabilized PEN (PolyEthylene Naphtalate) is available which is dimensionally stable up to more than 200°C, while its glass transition temperature is 120°C.

In order to raise the temperature in treatment space 5 various other embodiments may be used. Examples of such embodiments but are not limited thereto may be found in WO2008147184 from applicant, which is herein incorporated by reference.

Because of the fact, that pulsing reduces the formation of dust the power supply (as part of the plasma control unit 4) may be arranged to provide a periodic electrical signal with an on-time tₒₙ and an off-time t_{off}, the sum of the on-time and off-time being the period or cycle of the periodic electrical signal. The on-time may vary from very short, c.g. 20 µs, to short, e.g. 500 µs. The on-time effectively results in a pulse train having a series of sine wave periods at the operating frequency, with a total duration of the on-time (c.g. 10 to 30 periods of a sine wave) of 0.1 to 0.3 ms. However good results have been obtained using a duty cycle of 90 % up to 100% and an advantageous embodiment for the plasma apparatus arrangement for this invention has no off-time at all (i.e. duty cycle of 100%).

The power supply can be a power supply providing a wide range of frequencies. For example it can provide a low frequency (f=10-450 kHz) electrical signal during the on-time. It can also provide a high frequency electrical signal for example f = 450kHz - 30MHz. Also other frequencies can be provided like from 450kHz- 1 MHz or from 1 to 20MHz and the like.

The total amount of coagulation centers seem to be determined by the amount of the precursor of the chemical compound or chemical element to be deposited in the plasma gas composition, and the gas mixture used, for example the percentage of oxygen and of course the gas flow as discussed above. In case the precursor amount in the gas mixture is reduced and/or the amount of reactive gas like oxygen, the amount of coagulation centers in the plasma gas will also be reduced. Reducing the precursor amount in the gas composition will off course influence the efficiency of the deposition process. Best results are obtained in general with a precursor concentration ranging from 2 to 500 ppm of the gas composition.

Although oxygen as a reactive gas in this-illustrative example has many advantages also other reactive gases might be used like for example hydrogen, carbon dioxide, ammonia, oxides of nitrogen, and the like.

The formation of a glow discharge plasma may be stimulated by controlling the displacement current (dynamic matching) using the plasma control unit 4 connected to the electrodes 2, 3, leading to a uniform activation of the surface of substrate 6 in the treatment space 5. The plasma control unit 4 e.g. comprises a power supply and associated control circuitry as described in the pending international patent application PCT/NL2006/050209, and European patent applications EP-A-1381257,

EP-A-1626613 of applicant, which are herein incorporated by reference.

The formation of a glow discharge may be stimulated further by controlling the gap distance (g) which is the free distance in the treatment space between the at least 2 opposing electrodes and the total dielectric distance (d) which is the total dielectric thickness of the dielectric barrier and in which the product of gap distance and the total dielectric distance is less than or equal to 1.0 mm² or even more preferred les than 0.5 mm² as described in the not yet published EP08151765.8, EP08165019.4 and EP08168741.0 of same applicant, which are herein incorporated by reference.

In the present method precursors can be can be selected from (but are not limited to): W(CO)6, Ni(CO)4, Mo(CO)6, Co2(CO)8, Rh4(CO)12, Re2(CO)10, Cr(CO)6, or Ru3(CO)12, Bis(dimethylamino)dimethylsilane (BDMADMS), Tantalum Ethoxide (Ta(OC₂H₅)₅), Tetra Dimethyl amino Titanium (or TDMAT) SiH₄ CH₄, B₂H₆ or BCl₃, WF₆, TiCl₄, GeH4, Ge2H6Si2H6 (GeH3)3SiH,(GeH3)2SiH2, hexamethyldisiloxane (HMDSO), tetramethyldisiloxane (TMDSO), 1,1,3,3,5,5-hexamethyltrisiloxane, hexamethylcyclotetrasiloxane, octamethylcyclotetrasiloxane, decamethylcyclopentanesiloxane, tetraethoxysilane (TEOS), methyltrimethoxysilane, methyltriethoxysilane, dimethyldimethoxysilane, dimethyldiethoxysilane, trimethylethoxysilane, ethyltrimethoxysilane, ethyltriethoxysilane, n-propyltrimethoxysilane, n-propyltriethoxysilane, n-butyltrimethoxysilane, i-butyltrimethoxysilane, n-hexyltrimethoxysilane, phenyltrimethoxysilane, vinyltrimethoxysilane, vinyltriethoxysilane, aminomethyltrimethylsilane, dimethyldimethylaminosilane, dimethylaminotrimethylsilane, allylaminotrimethylsilane, diethylaminodimethylsilane, 1-trimethylsilylpyrrole, 1-trimethylsilylpyrrolidine, isopropylaminomethyltrimethylsilane, diethylaminotrimethylsilane, anilinotrimethylsilane, 2-piperidinoethyltrimethylsilane, 3-butylaminopropyltrimethylsilane, 3-piperidinopropyltrimethylsilane, bis(dimethylamino)methylsilane, 1-trimethylsilylimidazole, bis(ethylamino)dimethylsilane, bis(butylamino)dimethylsilane, 2-aminoethylaminomethyldimethylphenylsilane, 3-(4-methylpiperazinopropyl)trimethylsilane, dimethylphenylpiperazinomethylsilane, butyldimethyl-3-piperazinopropylsilane, dianilinodimethylsilane, bis(dimethylamino)diphenylsilane, 1,1,3,3-tetramethyldisilazane, 1,3-bis(chloromethyl)-1,1,3,3-tetramethyldisilazane, hexamethyldisilazane, 1,3-divinyl-1,1,3,3-tetramethyldisilazane, dibutyltin diacetate, aluminum isopropoxide, tris(2,4-pentadionato)aluminum, dibutyldiethoxytin, butyltin tris(2,4-pentanedionato), tetraethoxytin, methyltriethoxytin, diethyldiethoxytin, triisopropylethoxytin, ethylethoxytin, methylmethoxytin, isopropylisopropoxytin, tetrabutoxytin, diethoxytin, dimethoxytin, diisopropoxytin, dibutoxytin, dibutyryloxytin, diethyltin, tetrabutyltin, tin bis(2,4-pentanedionato), ethyltin acetoacetonato, ethoxytin (2,4-pentanedionato), dimethyltin (2,4-pentanedionato), diacetomethylacetatotin, diacetoxytin, dibutoxydiacetoxytin, diacetoxytin diacetoacetonato, tin hydride, tin dichloride, tin tetrachloride, triethoxytitanium, trimethoxytitanium, triisopropoxytitanium, tributoxytitanium, tetraethoxytitanium, tetraisopropoxytitanium, methyldimethoxytitanium, ethyltriethoxytitanium, methyltripropoxytitanium, triethyltitanium, triisopropyltitanium, tributyltitanium, tetraethyltitanium, tetraisopropyltitanium, tetrabutyltitanium, tetradimethylaminotitanium, dimethyltitanium di(2,4-pentanedionato), ethyltitanium tri(2,4-pentanedionato), titanium tris(2,4-pentanedionato), titanium tris(acetomethylacetato), triacetoxytitanium, dipropoxypropionyloxytitanium, dibutyryloxytitanium,monotitanium hydride, dititanium hydride, trichlorotitanium, tetrachlorotitanium, tetraethylsilane, tetramethylsilane, tetraisopropylsilane, tetrabutylsilane, tetraisopropoxysilane, diethylsilane di(2,4-pentanedionato), methyltriethoxysilane, ethyltriethoxysilane, silane tetrahydride, disilane hexahydride, tetrachlorosilane, methyltrichlorosilane, diethyldichlorosilane, isopropoxyaluminum, tris(2,4-pentanedionato)nickel, bis(2,4-pentanedionato)manganese, isopropoxyboron, tri-n-butoxyantimony, tri-n-butylantimony, di-n-butylbis(2,4-pentanedionato)tin, di-n-butyldiacetoxytin, di-t-butyldiacetoxytin, tetraisopropoxytin, zinc di(2,4-pentanedionate), and combinations thereof. Furthermore precursors can be used as for example described in EP-A-1351321 or EP-A-1371752. Generally the precursors are used in a concentration of 2-500 ppm e.g. around 50ppm of the total gas composition.

In one embodiment of this invention said precursor used in the deposition step of the first layer 6a is the same as in the deposition step of the second layer 6b.

In another embodiment of this invention said precursor used in the deposition step of the first layer 6a is different from the one as in the deposition step of the second layer 6b.

By this method and apparatus inorganic layers of a chemical compound or chemical element can be deposited on substrates 6 having a relatively low Tg, meaning that also common plastics, like polyethylene (PE), polypropylene (PP), Triacetylcellulose, PEN, PET, polycarbonate (PC) and the like can be provided with a deposition layer. Other substrates which can be chosen are for example UV stable polymer films such as ETFE or PTFE (from the group of fluorinated polymers) or silicone polymer foils. These polymers may even be reinforced by glass fibre to improve impact resistance.

Further the roughness parameter Rₐ of the (untreated) substrate 6 is in the range of 0.1 to 4 nm. Important in this respect is that the initial Rₐ of the substrate 6 is lower in nm than the first layer 6a deposition thickness d1. For these exemplary embodiments, a surface roughness Rₐ of the substrates 6 is thus in the range from 0.2 to 2 nm. Particular advantageous are embodiments in which the substrate 6 has a planarized layer and an average roughness of 1.0 nm or lower.

The substrates 6 provided with the two layers 6a, 6b according to the present invention embodiments can be used in a wide range of applications like wafer manufacturing, they can be used as barrier for plastics or applications where a conductive layer on an isolator is required and the like. The present invention embodiments can be used advantageously for producing substrates having properties suitable for applications in e.g. OLED devices, or more general for substrates in the form of films or foils which are usable for protecting against deterioration by water and/or oxygen and having smooth properties e.g. barrier films in the field of flexible Photo Voltaic-cells.

### EXAMPLES

In order to quantify water vapour transmission rates (WVTR) for barrier films (substrate 6 as treated in the above described plasma treatment apparatus 10) the Mocon Aquatran was used which uses a coulometric cell (electrochemical cell) with a minimum detection limit of 5*10⁻⁴ g/m².day. This method provides a more sensitive and accurate permeability evaluation than the permeation measurement by using IR absorption (known to the person skilled in the art). Measurement conditions can be varied from 10-40 °C and also relative humidity usually from 60-90%.

In order to quantify the surface roughness an AFM from Veeco Nano Scope IIIa, Veeco Meterology is used from which the Rₐ was calculated.

The Rₐ was determined as the arithmetic average of the absolute values of the measured height deviations within an evaluation area of 2 * 2 micron and measured from the mean surface.

The carbon concentration measurements for the deposited buffer layers A have been carried out in a Quantera from PHI (Q1). During the measurements the angle between the axis of the analyser and the sample surface was 45°, the information depth is then approximately 6 nm. The measurements have been performed using monochromatic AlKa-radiation in High Power mode (measuring spot 100 m, scanned over 1400 x 500 µ2).

Experiments have been carried out using the deposition embodiments as described above. First test samples were prepared by making a first layer 6a on the substrate 6. Fifteen PET substrates 6 having a Rₐ of lower than 1 nm and a WVTR of 2 g/m²*day were treated in the plasma treatment apparatus 10 as shown in Fig. 1. A precursor was used comprising HMDSN at 10g/hr. The other process parameters were varied as given in table 1, such as the energy supplied towards the substrate 6 and the oxygen concentration (O₂) in the treatment space 5.

**Table 1: Dependence Energy and oxygen-concentration on WVTR**

| | A1 | A2 | A3 | A4 | A5 | A6 | A7 | A8 | A9 | A10 | A11 | A12 | A13 | A14 | A15 |
|---|---|---|---|---|---|---|---|---|---|---|---|---|---|---|---|
| Energy (J/cm²) | 1.2 | 5 | 10 | 30 | 50 | 1.2 | 5 | 10 | 30 | 50 | 1.2 | 5 | 10 | 30 | 50 |
| [O₂] | 0.5 | 0.5 | 0.5 | 0.5 | 0.5 | 2 | 2 | 2 | 2 | 2 | 4 | 4 | 4 | 4 | 4 |
| Thickess Layer A (nm) | 7 | 10 | 10 | 10 | 10 | 7 | 10 | 10 | 10 | 10 | 7 | 10 | 10 | 10 | 10 |
| WVTR [g/m²*day] | 1.80 | 1.86 | 1.80 | 1.73 | 1.83 | 1.74 | 1.74 | 1.80 | 1.86 | 1.88 | 1.79 | 1.81 | 1.81 | 1.74 | 1.84 |
| Carbon content (wt%) | 15 | 9 | 4 | 5 | 1.8 | 14.5 | 11 | 5 | 2 | 1.8 | 1.8 | 1.6 | 1.5 | 1.4 | 1.1 |

As can be clearly seen from Table 1, the application of only a single layer 6a of inorganic material has virtually no influence on the WVTR, and does not provide the barrier improvement factor sought for the applications mentioned before.

The experiments have continued by applying a second layer 6b as specified in the embodiments as described above. To obtain comparison material, also substrates without a first layer 6a were treated by depositing a second layer 6b only. Four PET samples having a Rₐ of lower than 1 nm and a WVTR of 2 g/m²*day and several of the samples obtained with a first layer 6a (referenced as Ann in Table 2) were treated for deposition of a second layer 6b in the substrate treatment apparatus 10 as shown in Fig. 1. Table 2 is specifying the details of energy supplied towards the (layered) substrate 6 and the oxygen concentration in the treatment space 5. In the examples B1-B17, TEOS was used as precursor at 5 g/hr. In the examples B 18 and B 19, HMDSN was used as precursor at 10 g/hr.

**Table 2: Dependence Energy and oxygen-concentration on WVTR**

| | B1 | B2 | B3 | B4 | B5 | B6 | B7 | B8 | B9 | B10 |
|---|---|---|---|---|---|---|---|---|---|---|
| Layer A | no | no | no | no | A1 | A6 | A11 | A2 | A7 | A12 |
| Energy (J/cm²) | 30 | 30 | 80 | 80 | 80 | 80 | 80 | 80 | 80 | 80 |
| [O₂] | 0.5 | 4 | 0.5 | 4 | 4 | 4 | 4 | 4 | 4 | 4 |
| Thickess Layer B (nm) | 40 | 40 | 40 | 40 | 40 | 40 | 40 | 40 | 40 | 40 |
| WVTR [g/m²*day] | 1.73 | 0.84 | 0.94 | 1.7 * 10⁻² | 1.6* 10⁻³ | 3.3* 10⁻³ | 1.4 * 10⁻² | <5* 10⁻⁴ | 2.3* 10⁻³ | 1.5 * 10⁻² |
| Comperative/Inventive | C | C | C | C | I | I | C | I | I | C |
| | | | | | | | | | | |

| | B11 | B12 | B13 | B14 | B15 | B16 | B17 | B18 | B19 | |
|---|---|---|---|---|---|---|---|---|---|---|
| Layer A | A3 | A8 | A13 | A4 | A10 | A15 | A9 | A9 | A2 | |
| Energy (J/cm²) | 80 | 80 | 80 | 80 | 80 | 80 | 40 | 40 | 40 | |
| [O₂] | 4 | 4 | 4 | 4 | 4 | 4 | 3 | 3 | 4 | |
| Thickess Layer B (nm) | 40 | 40 | 40 | 40 | 40 | 40 | 40 | 40 | 40 | |
| WVTR [g/m²*day] | 5.6* 10⁻⁴ | 1.4* 10⁻³ | 1.8 * 10⁻² | 2.8* 10⁻³ | 1.7 * 10⁻² | 1.8 * 10⁻² | 5.5 * 10⁻³ | 6.7 * 10⁻³ | <5* 10⁻⁴ | |
| Comperative/ Inventive | I | I | C | I | C | C | I | I | I | |

Table 2 clearly shows that in many examples, in which the process conditions are within the ranges as specified above, the WVTR is drastically improved, sometimes even below the measurement limit of 5 * 10⁻⁴. These examples are indicated in table 2 as I (Inventive).

Comparison between examples B5 and B6, B8 and B9, and B11 and B12 show that when using an oxygen concentration of 0.5% during the deposition of the first layer 6a, a substrate 6 is obtained with an improved WVTR (improvement with a factor 2 or better).

Comparison between examples B 14 and B11 shows, that using an energy of 10 J/cm² during deposition of the first layer 6a yields an improvement with a factor of 5 compared to an energy of 30J/cm².

Comparison between examples B8 and B11 shows, that using an energy of 5 J/cm² during deposition of the first layer 6a yields a significant improvement compared to an energy of 10J/cm².

Comparison between examples B18 and B19 show that when using an oxygen concentration of 4% during the deposition of the second layer 6b, a substrate 6 is obtained with an improved WVTR as compared to an oxygen concentration of 3%.

## Claims

1. A method for producing a polymeric substrate using an atmospheric pressure glow discharge plasma in a treatment space formed between two or more opposing electrodes connected to a power supply, comprising
a) depositing a first layer of inorganic material on a polymeric substrate using a gas composition in the treatment space comprising a precursor and oxygen, said oxygen having a concentration of 2 % or less, and controlling the power supply to provide an energy across a gap between the two or more opposing electrodes of 30 J/cm² or less,
b) depositing a second layer of inorganic material on the first layer using a gas composition in the treatment space comprising a precursor and oxygen, said oxygen having a concentration of 3 % or higher, and controlling the power supply to provide an energy across the gap between the two or more opposing electrodes of 40 J/cm² or higher.

2. Method according to claim 1, in which the oxygen concentration when depositing the first layer is 0.5 % or less.

3. Method according to claim 1 or 2, in which the energy provided during deposition of the first layer is 10 J/cm² or less.

4. Method according to claim 1 or 2, in which the energy provided during deposition of the first layer is 5J/cm² or less.

5. Method according to any one of claims 1-4, in which the energy provided during deposition of the second layer is 80 J/cm² or higher.

6. Method according to any one of claims 1-5, in which the oxygen concentration when depositing the second layer is 4 % or higher.

7. Method according to any one of claims 1-6, in which the first layer of inorganic material is deposited until a thickness of 3 to 50 nm has been obtained.

8. Method according to any one of claims 1-7, in which the substrate is a moving substrate which is moved through the treatment space.

9. Method according to any one of claims 1-8, in which the substrate has an average surface roughness Rₐ of 2 nm or less.

10. Method according to any one of claims 1-9, in which the power supply (4) provides the energy with a duty cycle between 90 and 100%.

11. Method according to claim 10, in which the power supply (4) provides the energy with a duty cycle of 100%.

## Patentansprüche

1. Verfahren zum Erzeugen eines polymeren Substrats unter Verwendung eines Atmosphärendruck-Glimmentladungsplasmas in einem zwischen zwei oder mehr an eine Stromversorgung angeschlossenen, gegenüberliegenden Elektroden ausgebildeten Behandlungsraum, umfassend:
a) Abscheiden einer ersten Schicht aus anorganischem Material auf einem polymeren Substrat unter Verwendung einer Gaszusammensetzung in dem Behandlungsraum, umfassend einen Vorläufer und Sauerstoff, wobei der Sauerstoff eine Konzentration von 2% oder weniger aufweist, und Steuern der Stromversorgung, um eine Energie über einen Spalt zwischen den zwei oder mehr gegenüberliegenden Elektroden von 30 J/cm² oder weniger bereitzustellen,
b) Abscheiden einer zweiten Schicht aus anorganischem Material auf der ersten Schicht unter Verwendung einer Gaszusammensetzung in dem Behandlungsraum, umfassend einen Vorläufer und Sauerstoff, wobei der Sauerstoff eine Konzentration von 3% oder höher aufweist, und Steuern der Stromversorgung, um eine Energie über den Spalt zwischen den zwei oder mehr gegenüberliegenden Elektroden von 40 J/cm² oder mehr bereitzustellen.

2. Verfahren nach Anspruch 1, bei dem die Sauerstoffkonzentration beim Abscheiden der ersten Schicht 0,5% oder weniger beträgt.

3. Verfahren nach Anspruch 1 oder 2, bei dem die während der Abscheidung der ersten Schicht bereitgestellte Energie 10 J/cm² oder weniger beträgt.

4. Verfahren nach Anspruch 1 oder 2, bei dem die während der Abscheidung der ersten Schicht bereitgestellte Energie 5 J/cm² oder weniger beträgt.

5. Verfahren nach einem der Ansprüche 1-4, bei dem die während der Abscheidung der zweiten Schicht bereitgestellte Energie 80 J/cm² oder höher beträgt.

6. Verfahren nach einem der Ansprüche 1-5, bei dem die Sauerstoffkonzentration beim Abscheiden der zweiten Schicht 4% oder höher beträgt.

7. Verfahren nach einem der Ansprüche 1-6, bei dem die erste Schicht auf anorganischem Material abgeschieden wird, bis eine Dicke von 3 bis 50 nm erhalten worden ist.

8. Verfahren nach einem der Ansprüche 1-7, bei dem das Substrat ein bewegliches Substrat ist, das durch den Behandlungsraum bewegt wird.

9. Verfahren nach einem der Ansprüche 1-8, bei dem das Substrat eine mittlere Oberflächenrauheit Rₐ von 2 nm oder weniger aufweist.

10. Verfahren nach einem der Ansprüche 1-9, bei dem die Stromversorgung (4) die Energie mit einem Tastverhältnis zwischen 90 und 100% bereitstellt.

11. Verfahren nach Anspruch 10, bei dem die Stromversorgung (4) die Energie mit einem Tastverhältnis von 100% bereitstellt.

## Revendications

1. Procédé pour produire un substrat polymère en utilisant un plasma de décharge luminescente à pression atmosphérique dans un espace de traitement formé entre au moins deux électrodes opposées reliées à une alimentation, comprenant
a) le dépôt d'une première couche de matériau inorganique sur un substrat polymère en utilisant une composition gazeuse dans l'espace de traitement comprenant un précurseur et de l'oxygène, ledit oxygène ayant une concentration de 2 % ou moins, et le contrôle de l'alimentation pour fournir une énergie à travers un espace entre les au moins deux électrodes opposées de 30 J/cm² ou moins,
b) le dépôt d'une deuxième couche de matériau inorganique sur la première couche en utilisant une composition gazeuse dans l'espace de traitement comprenant un précurseur et de l'oxygène, ledit oxygène ayant une concentration de 3 % ou plus, et le contrôle de l'alimentation pour fournir une énergie à travers l'espace entre les au moins deux électrodes opposées de 40 J/cm² ou plus.

2. Procédé selon la revendication 1, dans lequel la concentration d'oxygène lors du dépôt de la première couche est de 0,5 % ou moins.

3. Procédé selon la revendication 1 ou 2, dans lequel l'énergie fournie lors du dépôt de la première couche est de 10 J/cm² ou moins.

4. Procédé selon la revendication 1 ou 2, dans lequel l'énergie fournie lors du dépôt de la première couche est de 5 J/cm² ou moins.

5. Procédé selon l'une quelconque des revendications 1 à 4, dans lequel l'énergie fournie lors du dépôt de la deuxième couche est de 80 J/cm² ou plus.

6. Procédé selon l'une quelconque des revendications 1 à 5, dans lequel la concentration d'oxygène lors du dépôt de la deuxième couche est de 4 % ou plus.

7. Procédé selon l'une quelconque des revendications 1 à 6, dans lequel la première couche de matériau inorganique est déposée jusqu'à ce qu'une épaisseur de 3 à 50 nm ait été obtenue.

8. Procédé selon l'une quelconque des revendications 1 à 7, dans lequel le substrat est un substrat mobile qui est déplacé à travers l'espace de traitement.

9. Procédé selon l'une quelconque des revendications 1 à 8, dans lequel le substrat a une rugosité de surface moyenne Rₐ de 2 nm ou moins.

10. Procédé selon l'une quelconque des revendications 1 à 9, dans lequel l'alimentation (4) fournit l'énergie avec un cycle de service compris entre 90 et 100 %.

11. Procédé selon la revendication 10, dans lequel l'alimentation (4) fournit l'énergie avec un cycle de service de 100 %.
